# EUROPEAN PATENT SPECIFICATION

(11) **EP 4 394 402 B1**
(45) Date of publication and mention of the grant of the patent: **16.09.2026**
(21) Application number: 22944426.0
(22) Date of filing: 28.06.2022
(51) Int. Cl.: G01R 31/00, G01R 19/165, G01R 31/327

(54) **ISOLATED FEEDBACK CIRCUIT FOR DETECTING OUTPUT STATE OF OPTOCOUPLER**
ISOLIERTE RÜCKKOPPLUNGSSCHALTUNG ZUR ERKENNUNG DES AUSGANGSSTATUS EINES OPTOKOPPLERS
CIRCUIT DE RÉTROACTION ISOLÉ POUR DÉTECTER L'ÉTAT DE SORTIE D'UN OPTOCOUPLEUR

(30) Priority: 31.05.2022 CN 202210612350
(43) Date of publication of application: 03.07.2024
(73) Proprietor: OPT Machine Vision Tech Co., Ltd., Chang'an Town Dongguan City, Guangdong Province 523000 (CN)
(72) Inventor: LI, Zhirong, Dongguan, Guangdong 523000 (CN)
(74) Representative: Zacco Sweden AB
(86) International application number: PCT/CN2022/101775
(87) International publication number: WO 2023/231108

(56) References cited:
- CN-A- 103 197 699
- CN-A- 109 712 574
- CN-A- 111 436 174
- CN-U- 202 373 972
- CN-U- 207 968 460
- CN-U- 214 125 565
- CN-U- 217 879 448
- JP-A- 2002 051 550
- US-A1- 2012 206 433
- US-A1- 2012 206 433
- CELDUC RELAIS: "SMB8670910 Datasheet", 13 October 2021 (2021-10-13), pages 1 - 7, XP093300639, Retrieved from the Internet <URL:https://www.e-catalogue.celduc-relais.com/gb/smb-2nd-generation/241-smb8670910.html?_gl=1*1evyrzh*_gcl_au*NzYyNzQ1MzkxLjE3NTM4MDM3MjQ.>

## Description

### TECHNICAL FIELD

The present invention relates to the technical field of semiconductor integrated circuits and, in particular, to an isolated feedback circuit for detecting an output state of an optocoupler.

### BACKGROUND

Optical coupler equipment (OCEP) is also known as an opto-isolator or an optocoupler (which is short for the optical coupler). The optocoupler is a device that uses light as a medium to transmit electrical signals. Since the optocoupler has a good isolation effect on inputted and outputted electrical signals, the optocoupler has been widely used in various circuits.

Currently, the isolation effect of the optocoupler causes that the input terminal of the optocoupler cannot directly learn the output state of the output terminal of the optocoupler. For example, when a control signal is inputted to the input terminal of the optocoupler, the input terminal of the optocoupler cannot learn whether the output terminal of the optocoupler performs the corresponding action according to the control signal, possibly causing that the input terminal cannot learn an abnormality of the output terminal of the optocoupler, not only affecting the normal output of the signal, but also possibly causing safety problems.

Prior art document CN207968460 discloses a first optocoupler with a feedback optocoupler for indicating the output state of the first optocoupler, in which the output state of the optocoupler is sensed directly.

Therefore, the existing art needs to be improved.

The preceding information is provided as background information merely for assisting in understanding the present disclosure, and it is not determined or acknowledged whether any of the preceding content can be used as the existing art relative to the present disclosure.

### SUMMARY

The present invention provides an isolated feedback circuit for detecting an output state of an optocoupler to solve the defects in the existing art.

To achieve the preceding object, the present invention provides the technical solutions described below.

An isolated feedback circuit for detecting an output state of an optocoupler is applied to an optocoupler module. A first input terminal of the optocoupler module is connected to a load, and the circuit includes a main control module, an output detection module, and an isolated feedback module.

The output detection module includes a current detection module, an upper current limit comparison module, a lower current limit comparison module, a voltage detection module, and a voltage comparison module.

A second input terminal of the optocoupler module is connected to an output terminal of the main control module, and an output terminal of the optocoupler module is connected to an input terminal of the current detection module.

An output terminal of the current detection module is separately connected to an input terminal of the upper current limit comparison module and an input terminal of the lower current limit comparison module.

Input terminals of the voltage detection module are connected in parallel with the load, and an output terminal of the voltage detection module is connected to an input terminal of the voltage comparison module.

An output terminal of the upper current limit comparison module is connected to a first input terminal of the isolated feedback module, an output terminal of the lower current limit comparison module is connected to a second input terminal of the isolated feedback module, and an output terminal of the voltage comparison module is connected to a third input terminal of the isolated feedback module.

An output terminal of the isolated feedback module is connected to an input terminal of the main control module.

The current detection module is configured to detect a load current at the output terminal of the optocoupler module and provide the load current for the upper current limit comparison module and the lower current limit comparison module.

The upper current limit comparison module is configured to compare the load current with a set upper current limit and determine whether the load current exceeds the upper current limit to obtain an upper current limit comparison result.

The lower current limit comparison module is configured to compare the load current with a set lower current limit and determine whether the load current reaches the lower current limit to obtain a lower current limit comparison result.

The voltage detection module is configured to detect a load voltage and provide the load voltage for the voltage comparison module.

The voltage comparison module is configured to compare the load voltage with a set short-circuit voltage and determine whether the load voltage reaches the short-circuit voltage to obtain a voltage comparison result.

The main control module is configured to output a conduction signal to turn on the optocoupler module and read the upper current limit comparison result, the lower current limit comparison result, and the voltage comparison result inputted by the isolated feedback module to learn whether the output terminal of the optocoupler module is turned on; and the main control module is configured to output a cutoff signal to cut off the optocoupler module and read the upper current limit comparison result, the lower current limit comparison result, and the voltage comparison result inputted by the isolated feedback module to learn whether the output terminal of the optocoupler module is cut off.

Further, in the isolated feedback circuit for detecting an output state of an optocoupler, the current detection module includes a first operational amplifier U3, a first resistor R1, and a third resistor R3.

A positive input terminal of the first operational amplifier U3 is connected to the optocoupler module, a negative input terminal of the first operational amplifier U3 is grounded through the first resistor R1, and an output terminal of the first operational amplifier U3 is connected to the upper current limit comparison module.

A terminal of the third resistor R3 is connected to the output terminal of the first operational amplifier U3, and the other terminal of the third resistor R3 is connected between the negative input terminal of the first operational amplifier U3 and the first resistor R1.

Further, in the isolated feedback circuit for detecting an output state of an optocoupler, the upper current limit comparison module includes a first voltage comparator U5, a fourteenth resistor R14, a fifteenth resistor R15, and a first voltage reference source VREF1.

A terminal of the fourteenth resistor R14 is connected to a power supply terminal of the first voltage comparator U5, the other terminal of the fourteenth resistor R14 is connected to a terminal of the fifteenth resistor R15, and the other terminal of the fifteenth resistor R15 is grounded.

A positive input terminal of the first voltage comparator U5 is connected to the first voltage reference source VREF 1 and then connected between the fourteenth resistor R14 and the fifteenth resistor R15.

A negative input terminal of the first voltage comparator U5 is connected to the output terminal of the first operational amplifier U3.

An output terminal of the first voltage comparator U5 is connected to the first input terminal of the isolated feedback module.

Further, in the isolated feedback circuit for detecting an output state of an optocoupler, the lower current limit comparison module includes a second voltage comparator U6, a sixteenth resistor R16, a seventeenth resistor R17, and a second voltage reference source VREF2.

A terminal of the sixteenth resistor R16 is connected to a power supply terminal of the second voltage comparator U6, the other terminal of the sixteenth resistor R16 is connected to a terminal of the seventeenth resistor R17, and the other terminal of the seventeenth resistor R17 is grounded.

A positive input terminal of the second voltage comparator U6 is connected to the second voltage reference source VREF2 and then connected between the sixteenth resistor R16 and the seventeenth resistor R17.

A negative input terminal of the second voltage comparator U6 is connected to the output terminal of the first operational amplifier U3.

An output terminal of the second voltage comparator U6 is connected to the second input terminal of the isolated feedback module.

Further, in the isolated feedback circuit for detecting an output state of an optocoupler, the voltage detection module includes a second operational amplifier U4, a twenty-sixth resistor R26, a twenty-seventh resistor R27, a twenty-eighth resistor R28, and a twenty-ninth resistor R29.

A positive input terminal of the second operational amplifier U4 is connected to a first terminal of the load through the twenty-seventh resistor R27, a negative input terminal of the second operational amplifier U4 is connected to a second terminal of the load through the twenty-sixth resistor R26, and an output terminal of the second operational amplifier U4 is connected to the input terminal of the voltage comparison module.

A terminal of the twenty-eighth resistor R28 is connected between the second operational amplifier U4 and the twenty-sixth resistor R26, and the other terminal of the twenty-eighth resistor R28 is connected to the output terminal of the second operational amplifier U4.

A terminal of the twenty-ninth resistor R29 is connected between the second operational amplifier U4 and the twenty-seventh resistor R27, and the other terminal of the twenty-ninth resistor R29 is grounded.

Further, in the isolated feedback circuit for detecting an output state of an optocoupler, the voltage comparison module includes a third voltage comparator U7, a twentieth resistor R20, a twenty-first resistor R21, and a third voltage reference source VREF3.

A terminal of the twentieth resistor R20 is connected to a power supply terminal of the third voltage comparator U7, the other terminal of the twentieth resistor R20 is connected to a terminal of the twenty-first resistor R21, and the other terminal of the twenty-first resistor R21 is grounded.

A positive input terminal of the third voltage comparator U7 is connected to the third voltage reference source VREF3 and then connected between the twentieth resistor R20 and the twenty-first resistor R21.

A negative input terminal of the third voltage comparator U7 is connected to the output terminal of the second operational amplifier U4.

An output terminal of the third voltage comparator U7 is connected to the third input terminal of the isolated feedback module.

Further, in the isolated feedback circuit for detecting an output state of an optocoupler, the isolated feedback module includes a first optocoupler U8, a second optocoupler U9, a third optocoupler U10, an isolation chip U11, a fifth resistor R5, a sixth resistor R6, a seventh resistor R7, an eighth resistor R8, a twenty-fourth resistor R24, and a twenty-fifth resistor R25.

A first pin of the first optocoupler U8 is connected to a terminal of the fifth resistor R5, a second pin of the first optocoupler U8 is connected to the output terminal of the first voltage comparator U5, a third pin of the first optocoupler U8 is grounded, and a fourth pin of the first optocoupler U8 is separately connected to a terminal of the seventh resistor R7 and the input terminal of the main control module.

A first pin of the second optocoupler U9 is connected to a terminal of the sixth resistor R6, a second pin of the second optocoupler U9 is connected to the output terminal of the second voltage comparator U6, a third pin of the second optocoupler U9 is grounded, and a fourth pin of the second optocoupler U9 is separately connected to a terminal of the eighth resistor R8 and the input terminal of the main control module.

A first pin of the third optocoupler U10 is connected to a terminal of the twenty-fourth resistor R24, a second pin of the third optocoupler U10 is connected to the output terminal of the third voltage comparator U7, a third pin of the third optocoupler U10 is grounded, and a fourth pin of the third optocoupler U10 is separately connected to a terminal of the twenty-fifth resistor R25 and the input terminal of the main control module.

Further, in the isolated feedback circuit for detecting an output state of an optocoupler, the main control module includes a main control chip U1, a ninth resistor R9, an eleventh resistor R11, a twelfth resistor R12, a thirteenth resistor R13, a first capacitor C1, a second capacitor C2, a third capacitor C3, and a crystal oscillator Y1.

APA0 pin of the main control chip U1 is connected to the second input terminal of the optocoupler module, a PA1 pin of the main control chip U1 is connected to the fourth pin of the first optocoupler U8, a PA2 pin of the main control chip U1 is connected to the fourth pin of the second optocoupler U9, and a PA3 pin of the main control chip U1 is connected to the fourth pin of the third optocoupler U10.

A terminal of the eleventh resistor R11 is connected to a BOOT2 pin of the main control chip U1, and the other terminal of the eleventh resistor R11 is grounded.

A terminal of the twelfth resistor R12 is connected to a BOOT1 pin of the main control chip U1, and the other terminal of the twelfth resistor R12 is grounded.

A terminal of the third capacitor C3 is connected to an OSC_0 pin of the main control chip U1, and the other terminal of the third capacitor C3 is grounded.

A terminal of the second capacitor C2 is connected to an OCS_1 pin of the main control chip U1, and the other terminal of the second capacitor C2 is grounded.

A terminal of the thirteenth resistor R13 is connected between the OSC_0 pin of the main control chip U1 and the third capacitor C3, and the other terminal of the thirteenth resistor R13 is connected between the OCS_1 pin of the main control chip U1 and the second capacitor C2.

A terminal of the crystal oscillator Y1 is connected between the OSC_0 pin of the main control chip U1 and the third capacitor C3, and the other terminal of the crystal oscillator Y1 is connected between the OCS_1 pin of the main control chip U1 and the second capacitor C2.

Further, in the isolated feedback circuit for detecting an output state of an optocoupler, the optocoupler module includes a fourth optocoupler U2, an N-channel metal oxide semiconductor (NMOS) transistor Q1, an eighteenth resistor R18, a nineteenth resistor R19, a parameter resistor Rout, and a second diode D2.

A first pin of the fourth optocoupler U2 is connected to the PA0 pin of the main control chip U1 through the eighteenth resistor R18, a second pin of the fourth optocoupler U2 is grounded, and a third pin of the fourth optocoupler U2 is connected to a gate of the NMOS transistor Q1.

A terminal of the nineteenth resistor R19 is connected between the third pin of the fourth optocoupler U2 and the gate of the NMOS transistor Q1, and the other terminal of the nineteenth resistor R19 is grounded.

A terminal of the parameter resistor Rout is connected to a source of the NMOS transistor Q1, and the other terminal of the parameter resistor Rout is grounded.

A drain of the NMOS transistor Q1 is connected to the second terminal of the load.

An anode of the second diode D2 is separately connected to the source of the NMOS transistor Q1 and the positive input terminal of the first operational amplifier U3, and a cathode of the second diode D2 is connected to the drain of the NMOS transistor Q1.

Further, in the isolated feedback circuit for detecting an output state of an optocoupler, the load includes a relay and a first diode D1.

A terminal of the relay is separately connected to the drain of the NMOS transistor Q1, the twenty-sixth resistor R26, and an anode of the first diode D1, and the other terminal of the relay is separately connected to the twenty-seventh resistor R27 and a cathode of the first diode D1.

Compared with the existing art, the embodiments of the present invention have the beneficial effects described below.

The embodiments of the present invention provide the isolated feedback circuit for detecting an output state of an optocoupler. The isolated feedback circuit is formed by the main control module, the output detection module, and the isolated feedback module, and the output state of the output terminal of the optocoupler module is quickly fed back to the main control module using simple level information. In this manner, the main control module can clearly learn the output state of the output terminal of the optocoupler module in real time and learn the abnormality of the output terminal of the optocoupler module in time, thereby reducing the impact on the normal output of the signal and avoiding safety problems.

### BRIEF DESCRIPTION OF DRAWINGS

To illustrate the technical solutions in embodiments of the present invention or the related art more clearly, the drawings used in the description of the embodiments or the related art are briefly described below. Apparently, the drawings described below illustrate only part of the embodiments of the present invention, and those of ordinary skill in the art may obtain other drawings based on the drawings described below on the premise that no creative work is done.
FIG. 1 is a schematic diagram illustrating circuit modules of an isolated feedback circuit for detecting an output state of an optocoupler according to an embodiment of the present invention; and
FIG. 2 is a circuit schematic diagram of an isolated feedback circuit for detecting an output state of an optocoupler according to an embodiment of the present invention.

### DETAILED DESCRIPTION

To make the purposes, features, and advantages of the present invention more apparent and easier to understand, the technical solutions in the embodiments of the present invention are described clearly and completely in conjunction with the drawings in the embodiments of the present invention. Apparently, the embodiments described below are part, not all, of the embodiments of the present invention. Based on the embodiments of the present invention, all other embodiments obtained by those of ordinary skill in the art are within the scope of the present invention on the premise that no creative work is done.

In the description of the present invention, it is to be understood that when a component is described as being "connected" to another component, the component may be directly connected to the other component or a centrally disposed component may exist at the same time. When a component is described as being "disposed on" another component, the component may be directly disposed on the other component or a centrally disposed component may exist at the same time.

In addition, orientation or position relationships indicated by terms such as "long", "short", "inside", and "outside" are based on the drawings, only for the convenience of describing the present invention and not to indicate or imply that the device or element referred to must have the specific orientation or be constructed in the specific orientation to operate, which cannot be understood as limiting the present invention.

The technical solutions of the present invention are further described hereinafter in conjunction with the drawings and embodiments.

### Embodiment one

Given the preceding existing shortcoming that the output state of the output terminal of the optocoupler cannot be learned, the applicant actively conducts research and innovation based on years of practical experience and professional knowledge in the design and manufacturing in this field and in conjunction with the application of science, hoping to create technologies that can solve the shortcoming in the existing art and making the output state of the output terminal of the optocoupler to be learned. After continuous research, design, repeated tests of samples and improvements, the present invention has finally been created with practical values.

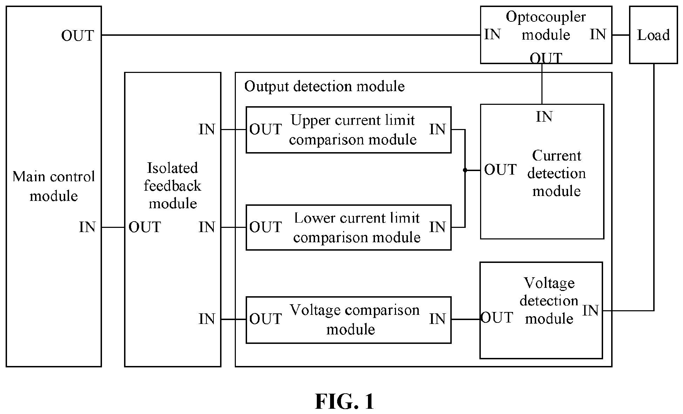

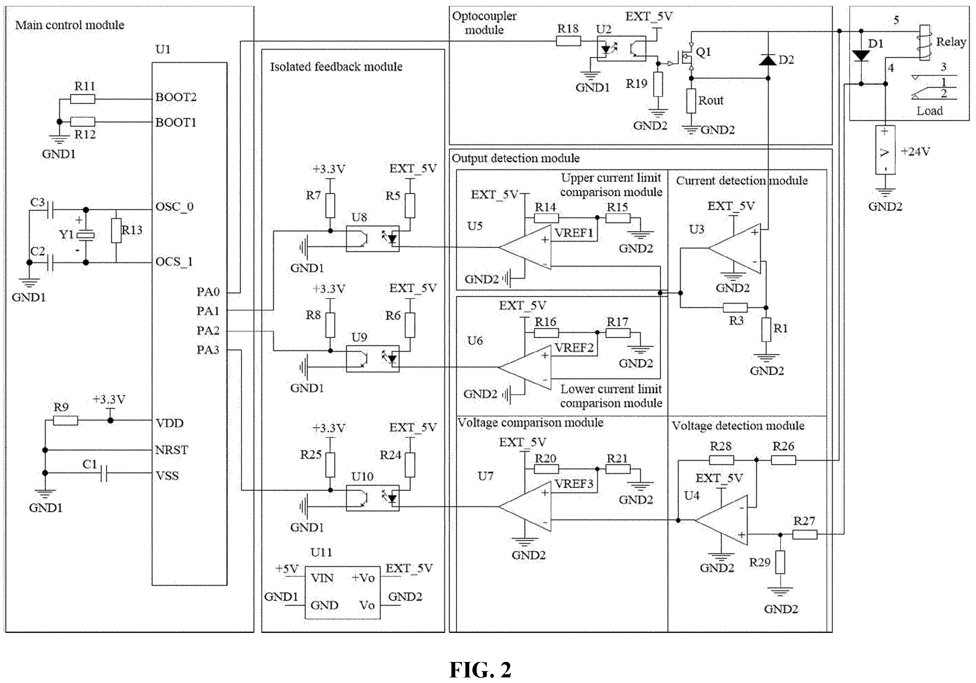

Referring to FIG. 1 and FIG. 2, the embodiments of the present invention provide an isolated feedback circuit for detecting an output state of an optocoupler applied to an optocoupler module. A first input terminal of the optocoupler module is connected to a load, and the circuit includes a main control module, an output detection module, and an isolated feedback module.

The output detection module includes a current detection module, an upper current limit comparison module, a lower current limit comparison module, a voltage detection module, and a voltage comparison module.

A second input terminal of the optocoupler module is connected to an output terminal of the main control module, and an output terminal of the optocoupler module is connected to an input terminal of the current detection module.

An output terminal of the current detection module is separately connected to an input terminal of the upper current limit comparison module and an input terminal of the lower current limit comparison module.

Input terminals of the voltage detection module are connected in parallel with the load, and an output terminal of the voltage detection module is connected to an input terminal of the voltage comparison module.

An output terminal of the upper current limit comparison module is connected to a first input terminal of the isolated feedback module, an output terminal of the lower current limit comparison module is connected to a second input terminal of the isolated feedback module, and an output terminal of the voltage comparison module is connected to a third input terminal of the isolated feedback module.

An output terminal of the isolated feedback module is connected to an input terminal of the main control module.

The current detection module is configured to detect a load current at the output terminal of the optocoupler module and provide the load current for the upper current limit comparison module and the lower current limit comparison module.

The upper current limit comparison module is configured to compare the load current with a set upper current limit and determine whether the load current exceeds the upper current limit, that is, whether the load current is an overcurrent, to obtain an upper current limit comparison result.

The lower current limit comparison module is configured to compare the load current with a set lower current limit for normal load operation and determine whether the load current reaches the lower current limit, that is, whether the circuit is an open circuit, to obtain a lower current limit comparison result.

The voltage detection module is configured to detect a load voltage and provide the load voltage for the voltage comparison module.

The voltage comparison module is configured to compare the load voltage with a set short-circuit voltage and determine whether the load voltage reaches the short-circuit voltage to obtain a voltage comparison result.

The main control module is configured to output a conduction signal to turn on the optocoupler module and read the upper current limit comparison result, the lower current limit comparison result, and the voltage comparison result inputted by the isolated feedback module to determine whether the output terminal of the optocoupler module is cut off, whether a short circuit occurs, whether the current is the overcurrent, or whether the output terminal of the optocoupler module is normally turned on, thereby learning whether the output terminal of the optocoupler module is turned on. Alternatively, the main control module is configured to output a cutoff signal to cut off the optocoupler module and read the upper current limit comparison result, the lower current limit comparison result, and the voltage comparison result inputted by the isolated feedback module to determine whether the output terminal of the optocoupler module is cut off, whether a short circuit occurs, whether the current is the overcurrent, or whether the output terminal of the optocoupler module is normally turned on, thereby learning whether the output terminal of the optocoupler module is cut off.

It is to be noted that the set upper current limit, the set lower current limit, and the set short-circuit voltage are all set by technicians through experience. This experience is based on specific experimental results, and each of the set upper current limit, the set lower current limit, and the set short-circuit voltage may be any value.

In this embodiment, the current detection module includes a first operational amplifier U3, a first resistor R1, and a third resistor R3.

A positive input terminal of the first operational amplifier U3 is connected to the optocoupler module, a negative input terminal of the first operational amplifier U3 is grounded (GND2) through the first resistor R1, and an output terminal of the first operational amplifier U3 is connected to the upper current limit comparison module.

A terminal of the third resistor R3 is connected to the output terminal of the first operational amplifier U3, and the other terminal of the third resistor R3 is connected between the negative input terminal of the first operational amplifier U3 and the first resistor R1.

A power supply terminal of the first operational amplifier U3 is connected to the voltage EXT_5V, and a ground terminal of the first operational amplifier U3 is grounded (GND2).

It is to be noted that the first operational amplifier U3 may be an operational amplifier with a product model of LM258, and the amplification factor is ${K}_{1} \left({K}_{1}=\frac{{R}_{1} + {R}_{3}}{{R}_{1}}=2\right)$. The resistance value of the first resistor R1 may be 5 kΩ. The resistance value of the third resistor R3 may be 5 kΩ.

In this embodiment, the upper current limit comparison module includes a first voltage comparator U5, a fourteenth resistor R14, a fifteenth resistor R15, and a first voltage reference source VREF1.

A terminal of the fourteenth resistor R14 is connected to a power supply terminal of the first voltage comparator U5, the other terminal of the fourteenth resistor R14 is connected to a terminal of the fifteenth resistor R15, and the other terminal of the fifteenth resistor R15 is grounded (GND2).

A positive input terminal of the first voltage comparator U5 is connected to the first voltage reference source VREF 1 and then connected between the fourteenth resistor R14 and the fifteenth resistor R15.

A negative input terminal of the first voltage comparator U5 is connected to the output terminal of the first operational amplifier U3.

An output terminal of the first voltage comparator U5 is connected to the first input terminal of the isolated feedback module.

The power supply terminal of the first voltage comparator U5 is connected to the voltage EXT_5V, and a ground terminal of the first voltage comparator U5 is grounded (GND2).

It is to be noted that the first voltage comparator U5 may be a voltage comparator with a product model of LM339, the resistance value of the fourteenth resistor R14 may be 3 kΩ, and the resistance value of the fifteenth resistor R15 may be 2 kΩ.

In this embodiment, the lower current limit comparison module includes a second voltage comparator U6, a sixteenth resistor R16, a seventeenth resistor R17, and a second voltage reference source VREF2.

A terminal of the sixteenth resistor R16 is connected to a power supply terminal of the second voltage comparator U6, the other terminal of the sixteenth resistor R16 is connected to a terminal of the seventeenth resistor R17, and the other terminal of the seventeenth resistor R17 is grounded (GND2).

A positive input terminal of the second voltage comparator U6 is connected to the second voltage reference source VREF2 and then connected between the sixteenth resistor R16 and the seventeenth resistor R17.

A negative input terminal of the second voltage comparator U6 is connected to the output terminal of the first operational amplifier U3.

An output terminal of the second voltage comparator U6 is connected to the second input terminal of the isolated feedback module.

The power supply terminal of the second voltage comparator U6 is connected to the voltage EXT_5V, and a ground terminal of the second voltage comparator U6 is grounded (GND2).

It is to be noted that the second voltage comparator U6 may be a voltage comparator with a product model of LM339, the resistance value of the sixteenth resistor R16 may be 4.8 kΩ, and the resistance value of the seventeenth resistor R17 may be 200 Ω.

In this embodiment, the voltage detection module includes a second operational amplifier U4, a twenty-sixth resistor R26, a twenty-seventh resistor R27, a twenty-eighth resistor R28, and a twenty-ninth resistor R29.

A positive input terminal of the second operational amplifier U4 is connected to a first terminal of the load through the twenty-seventh resistor R27, a negative input terminal of the second operational amplifier U4 is connected to a second terminal of the load through the twenty-sixth resistor R26, and an output terminal of the second operational amplifier U4 is connected to the input terminal of the voltage comparison module.

A terminal of the twenty-eighth resistor R28 is connected between the second operational amplifier U4 and the twenty-sixth resistor R26, and the other terminal of the twenty-eighth resistor R28 is connected to the output terminal of the second operational amplifier U4.

A terminal of the twenty-ninth resistor R29 is connected between the second operational amplifier U4 and the twenty-seventh resistor R27, and the other terminal of the twenty-ninth resistor R29 is grounded (GND2).

A power supply terminal of the second operational amplifier U4 is connected to the voltage EXT_5V, and a ground terminal of the second operational amplifier U4 is grounded (GND2).

It is to be noted that the second operational amplifier U4 may be an operational amplifier with a product model of LM258, and the amplification factor is ${K}_{2} \left({K}_{2}=\frac{{R}_{28}}{{R}_{26}}=0.1\right)$. The resistance value of the twenty-sixth resistor R26 may be 10 kΩ, the resistance value of the twenty-seventh resistor R27 may be 10 kΩ, the resistance value of the twenty-eighth resistor R28 may be 1 kΩ, and the resistance value of the twenty-ninth resistor R29 may be 1 kΩ.

In this embodiment, the voltage comparison module includes a third voltage comparator U7, a twentieth resistor R20, a twenty-first resistor R21, and a third voltage reference source VREF3.

A terminal of the twentieth resistor R20 is connected to a power supply terminal of the third voltage comparator U7, the other terminal of the twentieth resistor R20 is connected to a terminal of the twenty-first resistor R21, and the other terminal of the twenty-first resistor R21 is grounded (GND2).

A positive input terminal of the third voltage comparator U7 is connected to the third voltage reference source VREF3 and then connected between the twentieth resistor R20 and the twenty-first resistor R21.

A negative input terminal of the third voltage comparator U7 is connected to the output terminal of the second operational amplifier U4.

An output terminal of the third voltage comparator U7 is connected to the third input terminal of the isolated feedback module.

The power supply terminal of the third voltage comparator U7 is connected to the voltage EXT_5V, and a ground terminal of the third voltage comparator U7 is grounded (GND2).

It is to be noted that the third voltage comparator U7 may be a voltage comparator with a product model of LM339, the resistance value of the twentieth resistor R20 may be 4.8 kΩ, and the resistance value of the twenty-first resistor R21 may be 200 kΩ.

In this embodiment, the isolated feedback module includes a first optocoupler U8, a second optocoupler U9, a third optocoupler U10, an isolation chip U11, a fifth resistor R5, a sixth resistor R6, a seventh resistor R7, an eighth resistor R8, a twenty-fourth resistor R24, and a twenty-fifth resistor R25.

A first pin of the first optocoupler U8 is connected to a terminal of the fifth resistor R5, a second pin of the first optocoupler U8 is connected to the output terminal of the first voltage comparator U5, a third pin of the first optocoupler U8 is grounded (GND1), and a fourth pin of the first optocoupler U8 is separately connected to a terminal of the seventh resistor R7 and the input terminal of the main control module.

A first pin of the second optocoupler U9 is connected to a terminal of the sixth resistor R6, a second pin of the second optocoupler U9 is connected to the output terminal of the second voltage comparator U6, a third pin of the second optocoupler U9 is grounded (GND1), and a fourth pin of the second optocoupler U9 is separately connected to a terminal of the eighth resistor R8 and the input terminal of the main control module.

A first pin of the third optocoupler U10 is connected to a terminal of the twenty-fourth resistor R24, a second pin of the third optocoupler U10 is connected to the output terminal of the third voltage comparator U7, a third pin of the third optocoupler U10 is grounded (GND1), and a fourth pin of the third optocoupler U10 is separately connected to a terminal of the twenty-fifth resistor R25 and the input terminal of the main control module.

The other terminal of the seventh resistor R7, the other terminal of the eighth resistor R8, and the other terminal of the twenty-fifth resistor R25 are all connected to the voltage +3.3 V, and the other terminal of the fifth resistor R5, the other terminal of the sixth resistor R6, and the other terminal of the twenty-fourth resistor R24 are all connected to the voltage EXT_5V.

A VIN pin of the isolation chip U11 is connected to the voltage +5 V, a GND pin of the isolation chip U11 is grounded (GND1), a +Vo pin of the isolation chip U11 is connected to the voltage EXT_5V, and a Vo pin of the isolation chip U11 is grounded (GND2).

It is to be noted that the first optocoupler U8, the second optocoupler U9, and the third optocoupler U10 may each be an optocoupler with a model of TLP291, and the isolation chip U11 may be a chip with a model of IF0505S. The resistance value of the fifth resistor R5 may be 1 kΩ, the resistance value of the sixth resistor R6 may be 1 kΩ, the resistance value of the seventh resistor R7 may be 1 kΩ, the resistance value of the eighth resistor R8 may be 1 kΩ, the resistance value of the twenty-fourth resistor R24 may be 1 kΩ, and the resistance value of the twenty-fifth resistor R25 may be 1 kΩ.

The isolated feedback module isolates the voltage 5 V and GND1 for the main control module from the voltage EXT_5V and GND2 for the output detection module and the optocoupler module.

In this embodiment, the main control module includes a main control chip U1, a ninth resistor R9, an eleventh resistor R11, a twelfth resistor R12, a thirteenth resistor R13, a first capacitor C1, a second capacitor C2, a third capacitor C3, and a crystal oscillator Y1.

APA0 pin of the main control chip U1 is connected to the second input terminal of the optocoupler module, a PA1 pin of the main control chip U1 is connected to the fourth pin of the first optocoupler U8, a PA2 pin of the main control chip U1 is connected to the fourth pin of the second optocoupler U9, and a PA3 pin of the main control chip U1 is connected to the fourth pin of the third optocoupler U10.

A terminal of the eleventh resistor R11 is connected to a BOOT2 pin of the main control chip U1, and the other terminal of the eleventh resistor R11 is grounded (GND1).

A terminal of the twelfth resistor R12 is connected to a BOOT1 pin of the main control chip U1, and the other terminal of the twelfth resistor R12 is grounded (GND1).

A terminal of the third capacitor C3 is connected to an OSC_0 pin of the main control chip U1, and the other terminal of the third capacitor C3 is grounded (GND1).

A terminal of the second capacitor C2 is connected to an OCS_1 pin of the main control chip U1, and the other terminal of the second capacitor C2 is grounded (GND1).

A terminal of the thirteenth resistor R13 is connected between the OSC_0 pin of the main control chip U1 and the third capacitor C3, and the other terminal of the thirteenth resistor R13 is connected between the OCS_1 pin of the main control chip U1 and the second capacitor C2.

A terminal of the crystal oscillator Y1 is connected between the OSC_0 pin of the main control chip U1 and the third capacitor C3, and the other terminal of the crystal oscillator Y1 is connected between the OCS_1 pin of the main control chip U1 and the second capacitor C2.

It is to be noted that the main control chip U1 may be a chip with a model of STM32F103, the resistance value of the ninth resistor R9 may be 10 kΩ, the resistance value of the eleventh resistor R11 may be 10 kΩ, the resistance value of the twelfth resistor R12 may be 10 kΩ, the resistance value of the thirteenth resistor R13 may be 1 MΩ, the capacitance value of the first capacitor C1 may be 0.1 uF, the capacitance value of the second capacitor C2 may be 24 pF, the capacitance value of the third capacitor C3 may be 24 pF, and the frequency of the crystal oscillator Y1 may be 8 MHz.

In this embodiment, the optocoupler module includes a fourth optocoupler U2, an NMOS transistor Q1, an eighteenth resistor R18, a nineteenth resistor R19, a parameter resistor Rout, and a second diode D2.

A first pin of the fourth optocoupler U2 is connected to the PA0 pin of the main control chip U1 through the eighteenth resistor R18, a second pin of the fourth optocoupler U2 is grounded (GND1), and a third pin of the fourth optocoupler U2 is connected to a gate of the NMOS transistor Q1.

A terminal of the nineteenth resistor R19 is connected between the third pin of the fourth optocoupler U2 and the gate of the NMOS transistor Q1, and the other terminal of the nineteenth resistor R19 is grounded (GND2).

A terminal of the parameter resistor Rout is connected to a source of the NMOS transistor Q1, and the other terminal of the parameter resistor Rout is grounded (GND2).

A drain of the NMOS transistor Q1 is connected to the second terminal of the load.

An anode of the second diode D2 is separately connected to the source of the NMOS transistor Q1 and the positive input terminal of the first operational amplifier U3, and a cathode of the second diode D2 is connected to the drain of the NMOS transistor Q1.

A fourth pin of the fourth optocoupler U2 is connected to the voltage EXT_5V.

It is to be noted that the fourth optocoupler U2 may be an optocoupler with a model of TLP291, the NMOS transistor Q1 may be an NMOS transistor with a model of 50N06, the resistance value of the eighteenth resistor R18 may be 1 kΩ, the resistance value of the nineteenth resistor R19 may be 51 kΩ, the resistance value of the parameter resistor Rout may be 10 Ω, and the second diode D2 may be a diode with a model of IN4007.

In this embodiment, the load includes a relay and a first diode D1.

One terminal of the relay is separately connected to the drain of the NMOS transistor Q1, the twenty-sixth resistor R26, and an anode of the first diode D1, and the other terminal of the relay is separately connected to the twenty-seventh resistor R27 and a cathode of the first diode D1.

It is to be noted that the first diode D1 may be a diode with a model of IN4007.

The implementation principle steps are described below.
(1) If the upper current limit set for the upper current limit comparison module is *I*ₘₐₓ, and *I*ₘₐₓ *=* 100 mA, the first voltage reference source in the upper current limit comparison module is *V_{ref1},* and *V_{ref1}* = *I*ₘₐₓ**R*ₒᵤt**K*₁ = 0.1 * 10 * 2 = 2 V. If the output current of the optocoupler is greater than 100 mA, the isolated feedback module inputs a low level to the PA1 pin of the main control module. If the output current of the optocoupler module is less than 100 mA, the isolated feedback module inputs a high level to the PA1 pin of the main control module.
(2) If the lower current limit set for the lower current limit comparison module is *Iₘᵢₙ,* and *Iₘᵢₙ =* 10 mA, the second voltage reference source in the lower current limit comparison module is *V_{ref2},* and *V_{ref2}* = *I*ₘᵢₙ**R*ₒᵤₜ**K*₁ = 0.01 * 10 * 2 = 0.2 V. If the output current of the optocoupler is greater than 10 mA, the isolated feedback module inputs a low level to the PA2 pin of the main control module. If the output current of the optocoupler is less than 10 mA, the isolated feedback module inputs a high level to the PA2 pin of the main control module.
(3) If the short-circuit voltage set for the voltage comparison module is *Vₛₕₒᵣₜ,* and *Vₛₕₒᵣₜ =* 2 V, the third voltage reference source in the voltage comparison module is *V_{ref3},* and *V_{ref3} = Vₛₕₒᵣₜ * K₂ =* 2 * 0.1 = 0.2 V. If the voltage across the load connected to the input terminal of the optocoupler module is greater than 2 V, the isolated feedback module inputs a low level to the PA3 pin of the main control module. If the voltage across the load connected to the input terminal of the optocoupler module is less than 2 V, the isolated feedback module inputs a high level to the PA3 pin of the main control module.
(4) In the case where the main control module outputs a conduction signal to turn on the optocoupler module, the main control module reads the upper current limit comparison result, the lower current limit comparison result, and the voltage comparison result inputted by the isolated feedback module. If the main control module reads that the PA1 pin receives a high level, the PA2 pin receives a low level, and the PA3 pin receives a low level, it means that the output terminal of the optocoupler module is normally turned on. If the main control module reads that the PA1 pin receives a high level and the PA2 pin receives a high level, it means that the output terminal is cut off. If the main control module reads that the PA1 pin receives a low level and the PA2 pin receives a low level, it means that the output terminal has an overcurrent. If the main control module reads that the PA2 pin receives a low level and the PA3 pin receives a high level, it means that the output terminal is short-circuited, thereby learning whether the output terminal of the optocoupler module is normally turned on.
(5) In the case where the main control module outputs a cutoff signal to cut off the optocoupler module, the main control module reads the upper current limit comparison result, the lower current limit comparison result, and the voltage comparison result inputted by the isolated feedback module. If the main control module reads that the PA1 pin receives a high level, the PA2 pin receives a low level, and the PA3 pin receives a low level, it means that the output terminal of the optocoupler module is normally turned on. If the main control module reads that the PA1 pin receives a high level and the PA2 pin receives a high level, it means that the output terminal is cut off. If the main control module reads that the PA1 pin receives a low level and the PA2 pin receives a low level, it means that the output terminal has an overcurrent. If the main control module reads that the PA2 pin receives a low level and the PA3 pin receives a high level, it means that the output terminal is short-circuited, thereby learning whether the output terminal of the optocoupler module is cut off.

Although the terms such as the main control module, the optocoupler module, the output detection module, the isolated feedback module, and the load are often used in this article, the possibility of using other terms is not ruled out..

The embodiments of the present invention provide the isolated feedback circuit for detecting the output state of an optocoupler. The isolated feedback circuit is formed by the main control module, the output detection module, and the isolated feedback module, and the output state of the output terminal of the optocoupler module is quickly fed back to the main control module using simple level information. In this manner, the main control module can clearly learn the output state of the output terminal of the optocoupler module in real time and learn the abnormality of the output terminal of the optocoupler module in time, thereby reducing the impact on the normal output of the signal and avoiding safety problems.

At this point, the description of the preceding embodiments is provided for the purpose of illustration and description. It is not intended to be exhaustive or to limit the present disclosure. Individual elements or features of the specific embodiments are usually not limited by the specific embodiments, but when applicable, can be interchanged and used for selected embodiments even if not specifically shown or described. In many aspects, the same elements or features may also be changed. This change is not considered as a deviation from the present disclosure, and all such modifications are intended to be included within the scope of the present disclosure.

Example embodiments are provided so that the present disclosure becomes thorough and fully conveys the scope to those skilled in the art. For a thorough understanding of the embodiments of the present disclosure, numerous details are set forth, such as examples of specific parts, devices, and methods. Apparently, for those skilled in the art, specific details are not required, example embodiments may be implemented in many different forms, and neither should be construed as limiting the scope of the present disclosure. In some example embodiments, well-known procedures, well-known device structures, and well-known technologies are not described in detail.

Specialized vocabulary used here is merely used for describing particular example embodiments and is not intended to be limiting. Unless the context clearly indicates the contrary, singular forms "a", "an", and "the" used here may be intended to include plural forms. The terms "including" and "having" mean to be inclusive and thus are to specify the presence of the described features, wholes, steps, operations, elements, and/or components, but are not to exclude the presence or additional presence of one or more other features, wholes, steps, operations, elements, components, and/or combinations thereof. Unless the order of execution is clearly indicated, the method steps, processing, and operations described here are not to be construed as necessarily being executed in the particular order described and illustrated. It is also to be understood that additional or optional steps may be used.

When an element or layer is described as "on", "engaged with", "connected to", or "joined to" another element or layer, the element or layer may be directly on the other element or layer, the element or layer may be directly engaged with the other element or layer, the element or layer may be directly connected or joined to the other element or layer, or an intervening element or layer may exist. Rather, when an element or layer is described as "directly on", "directly engaged with", "directly connected to", or "directly joined to" another element or layer, an intervening element or layer may not exist. Other words used for describing element relationships should be explained in a similar manner (such as "between", "directly between", "adjacent", or "directly adjacent"). The term "and/or" used herein includes any and all combinations of one or more of the associated listed items. Although the terms such as first, second, and third are possibly used here for describing various elements, components, regions, layers, and/or portions, these elements, components, regions, layers, and/or portions are not limited by these terms. These terms may be merely used for distinguishing one element, component, region, or portion from another. Unless clearly indicated by the context, the terms such as "first", "second", and other numerical value terms used here do not indicate a sequence or order. Therefore, a first element, component, region, layer, or portion that is described below may use the term of a second element, component, region, layer, or portion without departing from the guidance of the example embodiment.

Relative spatial terms such as "inside", "outside", "below", "under", "lower part", "over", or "upper part" may be used here for ease of description to describe a relationship between one element or feature and another or more elements or features as shown in the figures. The relative spatial terms may be intended to include different orientations of a device, in addition to those shown in the figures. For example, if the device in the figure is flipped, an element described as being "under another element or feature" or "below another element or feature" is oriented as "above another element or feature". Therefore, the example term "under" may include two orientations: upward and downward. The device may be otherwise oriented (rotated by 90 degrees or otherwise oriented) and explained by a relative description of the space here.

## Claims

1. An isolated feedback circuit for detecting an output state of an optocoupler, applied to an optocoupler module, wherein a first input terminal of the optocoupler module is connected to a load, and the circuit comprises a main control module, an output detection module, and an isolated feedback module; wherein
the output detection module comprises a current detection module, an upper current limit comparison module, a lower current limit comparison module, a voltage detection module, and a voltage comparison module;
a second input terminal of the optocoupler module is connected to an output terminal of the main control module, and an output terminal of the optocoupler module is connected to an input terminal of the current detection module;
an output terminal of the current detection module is separately connected to an input terminal of the upper current limit comparison module and an input terminal of the lower current limit comparison module;
input terminals of the voltage detection module are connected in parallel with the load, and an output terminal of the voltage detection module is connected to an input terminal of the voltage comparison module;
an output terminal of the upper current limit comparison module is connected to a first input terminal of the isolated feedback module, an output terminal of the lower current limit comparison module is connected to a second input terminal of the isolated feedback module, and an output terminal of the voltage comparison module is connected to a third input terminal of the isolated feedback module;
an output terminal of the isolated feedback module is connected to an input terminal of the main control module;
the current detection module is configured to detect a load current at the output terminal of the optocoupler module and provide the load current for the upper current limit comparison module and the lower current limit comparison module;
the upper current limit comparison module is configured to compare the load current with a set upper current limit and determine whether the load current exceeds the upper current limit to obtain an upper current limit comparison result;
the lower current limit comparison module is configured to compare the load current with a set lower current limit and determine whether the load current reaches the lower current limit to obtain a lower current limit comparison result;
the voltage detection module is configured to detect a load voltage and provide the load voltage for the voltage comparison module;
the voltage comparison module is configured to compare the load voltage with a set short-circuit voltage and determine whether the load voltage reaches the short-circuit voltage to obtain a voltage comparison result; and
the main control module is configured to output a conduction signal to turn on the optocoupler module and read the upper current limit comparison result, the lower current limit comparison result, and the voltage comparison result inputted by the isolated feedback module to learn whether the output terminal of the optocoupler module is turned on; and the main control module is configured to output a cutoff signal to cut off the optocoupler module and read the upper current limit comparison result, the lower current limit comparison result, and the voltage comparison result inputted by the isolated feedback module to learn whether the output terminal of the optocoupler module is cut off.

2. The isolated feedback circuit of claim 1, wherein the current detection module comprises a first operational amplifier (U3), a first resistor (R1), and a third resistor (R3);
wherein a positive input terminal of the first operational amplifier (U3) is connected to the optocoupler module, a negative input terminal of the first operational amplifier (U3) is grounded through the first resistor (R1), and an output terminal of the first operational amplifier (U3) is connected to the upper current limit comparison module; and
a terminal of the third resistor (R3) is connected to the output terminal of the first operational amplifier (U3), and another terminal of the third resistor (R3) is connected between the negative input terminal of the first operational amplifier (U3) and the first resistor (R1).

3. The isolated feedback circuit of claim 2, wherein the upper current limit comparison module comprises a first voltage comparator (U5), a fourteenth resistor (R14), a fifteenth resistor (R15), and a first voltage reference source (VREF1);
wherein a terminal of the fourteenth resistor (R14) is connected to a power supply terminal of the first voltage comparator (U5), another terminal of the fourteenth resistor (R14) is connected to a terminal of the fifteenth resistor (R15), and another terminal of the fifteenth resistor (R15) is grounded;
a positive input terminal of the first voltage comparator (U5) is connected to the first voltage reference source (VREF1) and then connected between the fourteenth resistor (R14) and the fifteenth resistor (R15);
a negative input terminal of the first voltage comparator (U5) is connected to the output terminal of the first operational amplifier (U3); and
an output terminal of the first voltage comparator (U5) is connected to the first input terminal of the isolated feedback module.

4. The isolated feedback circuit of claim 3, wherein the lower current limit comparison module comprises a second voltage comparator (U6), a sixteenth resistor (R16), a seventeenth resistor (R17), and a second voltage reference source (VREF2);
wherein a terminal of the sixteenth resistor (R16) is connected to a power supply terminal of the second voltage comparator (U6), another terminal of the sixteenth resistor (R16) is connected to a terminal of the seventeenth resistor (R17), and another terminal of the seventeenth resistor (R17) is grounded;
a positive input terminal of the second voltage comparator (U6) is connected to the second voltage reference source (VREF2) and then connected between the sixteenth resistor (R16) and the seventeenth resistor (R17);
a negative input terminal of the second voltage comparator (U6) is connected to the output terminal of the first operational amplifier (U3); and
an output terminal of the second voltage comparator (U6) is connected to the second input terminal of the isolated feedback module.

5. The isolated feedback circuit of claim 4, wherein the voltage detection module comprises a second operational amplifier (U4), a twenty-sixth resistor (R26), a twenty-seventh resistor (R27), a twenty-eighth resistor (R28), and a twenty-ninth resistor (R29);
wherein a positive input terminal of the second operational amplifier (U4) is connected to a first terminal of the load through the twenty-seventh resistor (R27), a negative input terminal of the second operational amplifier (U4) is connected to a second terminal of the load through the twenty-sixth resistor (R26), and an output terminal of the second operational amplifier (U4) is connected to the input terminal of the voltage comparison module;
a terminal of the twenty-eighth resistor (R28) is connected between the second operational amplifier (U4) and the twenty-sixth resistor (R26), and another terminal of the twenty-eighth resistor (R28) is connected to the output terminal of the second operational amplifier (U4); and
a terminal of the twenty-ninth resistor (R29) is connected between the second operational amplifier (U4) and the twenty-seventh resistor (R27), and another terminal of the twenty-ninth resistor (R29) is grounded.

6. The isolated feedback circuit of claim 5, wherein the voltage comparison module comprises a third voltage comparator (U7), a twentieth resistor (R20), a twenty-first resistor (R21), and a third voltage reference source (VREF3);
wherein a terminal of the twentieth resistor (R20) is connected to a power supply terminal of the third voltage comparator (U7), another terminal of the twentieth resistor (R20) is connected to a terminal of the twenty-first resistor (R21), and another terminal of the twenty-first resistor (R21) is grounded;
a positive input terminal of the third voltage comparator (U7) is connected to the third voltage reference source (VREF3) and then connected between the twentieth resistor (R20) and the twenty-first resistor (R21);
a negative input terminal of the third voltage comparator (U7) is connected to the output terminal of the second operational amplifier (U4); and
an output terminal of the third voltage comparator (U7) is connected to the third input terminal of the isolated feedback module.

7. The isolated feedback circuit of claim 6, wherein the isolated feedback module comprises a first optocoupler (U8), a second optocoupler (U9), a third optocoupler (U10), an isolation chip (U11), a fifth resistor (R5), a sixth resistor (R6), a seventh resistor (R7), an eighth resistor (R8), a twenty-fourth resistor (R24), and a twenty-fifth resistor (R25);
wherein a first pin of the first optocoupler (U8) is connected to a terminal of the fifth resistor (R5), a second pin of the first optocoupler (U8) is connected to the output terminal of the first voltage comparator (U5), a third pin of the first optocoupler (U8) is grounded, and a fourth pin of the first optocoupler (U8) is separately connected to a terminal of the seventh resistor (R7) and the input terminal of the main control module;
a first pin of the second optocoupler (U9) is connected to a terminal of the sixth resistor (R6), a second pin of the second optocoupler (U9) is connected to the output terminal of the second voltage comparator (U6), a third pin of the second optocoupler (U9) is grounded, and a fourth pin of the second optocoupler (U9) is separately connected to a terminal of the eighth resistor (R8) and the input terminal of the main control module; and
a first pin of the third optocoupler (U10) is connected to a terminal of the twenty-fourth resistor (R24), a second pin of the third optocoupler (U10) is connected to the output terminal of the third voltage comparator (U7), a third pin of the third optocoupler (U10) is grounded, and a fourth pin of the third optocoupler (U10) is separately connected to a terminal of the twenty-fifth resistor (R25) and the input terminal of the main control module.

8. The isolated feedback circuit of claim 7, wherein the main control module comprises a main control chip (U1), a ninth resistor (R9), an eleventh resistor (R11), a twelfth resistor (R12), a thirteenth resistor (R13), a first capacitor (C1), a second capacitor (C2), a third capacitor (C3), and a crystal oscillator (Y1);
wherein a PA0 pin of the main control chip (U1) is connected to the second input terminal of the optocoupler module, a PA1 pin of the main control chip (U1) is connected to the fourth pin of the first optocoupler (U8), a PA2 pin of the main control chip (U1) is connected to the fourth pin of the second optocoupler (U9), and a PA3 pin of the main control chip (U1) is connected to the fourth pin of the third optocoupler (U10);
a terminal of the eleventh resistor (R11) is connected to a BOOT2 pin of the main control chip (U1), and another terminal of the eleventh resistor (R11) is grounded;
a terminal of the twelfth resistor (R12) is connected to a BOOT1 pin of the main control chip (U1), and another terminal of the twelfth resistor (R12) is grounded;
a terminal of the third capacitor (C3) is connected to an OSC_0 pin of the main control chip (U1), and another terminal of the third capacitor (C3) is grounded;
a terminal of the second capacitor (C2) is connected to an OCS_1 pin of the main control chip (U1), and another terminal of the second capacitor (C2) is grounded;
a terminal of the thirteenth resistor (R13) is connected between the OSC_0 pin of the main control chip (U1) and the third capacitor (C3), and another terminal of the thirteenth resistor (R13) is connected between the OCS_1 pin of the main control chip (U1) and the second capacitor (C2); and
a terminal of the crystal oscillator (Y1) is connected between the OSC_0 pin of the main control chip (U1) and the third capacitor (C3), and another terminal of the crystal oscillator (Y1) is connected between the OCS_1 pin of the main control chip U1 and the second capacitor (C2).

9. The isolated feedback circuit of claim 8, wherein the optocoupler module comprises a fourth optocoupler (U2), an N-channel metal oxide semiconductor, NMOS, transistor (Q1), an eighteenth resistor (R18), a nineteenth resistor (R19), a parameter resistor (Rout), and a second diode (D2);
wherein a first pin of the fourth optocoupler (U2) is connected to the PA0 pin of the main control chip (U1) through the eighteenth resistor (R18), a second pin of the fourth optocoupler (U2) is grounded, and a third pin of the fourth optocoupler (U2) is connected to a gate of the NMOS transistor (Q1);
a terminal of the nineteenth resistor (R19) is connected between the third pin of the fourth optocoupler (U2) and the gate of the NMOS transistor (Q1), and another terminal of the nineteenth resistor (R19) is grounded;
a terminal of the parameter resistor Rout is connected to a source of the NMOS transistor Q1, and another terminal of the parameter resistor Rout is grounded;
a drain of the NMOS transistor (Q1) is connected to the second terminal of the load; and
an anode of the second diode (D2) is separately connected to the source of the NMOS transistor (Q1) and the positive input terminal of the first operational amplifier (U3), and a cathode of the second diode (D2) is connected to the drain of the NMOS transistor (Q1).

10. The isolated feedback circuit of claim 9, wherein the load comprises a relay and a first diode (D1);
wherein a terminal of the relay is separately connected to the drain of the NMOS transistor (Q1), the twenty-sixth resistor (R26) and an anode of the first diode (D1), and another terminal of the relay is separately connected to the twenty-seventh resistor (R27) and a cathode of the first diode (D1).

## Patentansprüche

1. Isolierte Rückkopplungsschaltung zum Erfassen eines Ausgangszustands eines Optokopplers, angewendet auf ein Optokopplermodul, wobei ein erster Eingangsanschluss des Optokopplermoduls mit einer Last verbunden ist, und die Schaltung ein Hauptsteuermodul, ein Ausgangserfassungsmodul und ein isoliertes Rückkopplungsmodul umfasst; wobei
das Ausgangserfassungsmodul ein Stromerfassungsmodul, ein Oberstromgrenzwert-Vergleichsmodul, ein Unterstromgrenzwert-Vergleichsmodul, ein Spannungserfassungsmodul und ein Spannungsvergleichsmodul umfasst;
ein zweiter Eingangsanschluss des Optokopplermoduls mit einem Ausgangsanschluss des Hauptsteuermoduls verbunden ist und ein Ausgangsanschluss des Optokopplermoduls mit einem Eingangsanschluss des Stromerfassungsmoduls verbunden ist;
ein Ausgangsanschluss des Stromerfassungsmoduls jeweils mit einem Eingangsanschluss des Oberstromgrenzwert-Vergleichsmoduls und einem Eingangsanschluss des Unterstromgrenzwert-Vergleichsmoduls verbunden ist;
die Eingangsanschlüsse des Spannungserfassungsmoduls parallel zur Last geschaltet sind und ein Ausgangsanschluss des Spannungserfassungsmoduls mit einem Eingangsanschluss des Spannungsvergleichsmoduls verbunden ist;
ein Ausgangsanschluss des Oberstromgrenzwert-Vergleichsmoduls mit einem ersten Eingangsanschluss des isolierten Rückkopplungsmoduls verbunden ist, ein Ausgangsanschluss des Unterstromgrenzwert-Vergleichsmoduls mit einem zweiten Eingangsanschluss des isolierten Rückkopplungsmoduls verbunden ist und ein Ausgangsanschluss des Spannungsvergleichsmoduls mit einem dritten Eingangsanschluss des isolierten Rückkopplungsmoduls verbunden ist;
ein Ausgangsanschluss des isolierten Rückkopplungsmoduls mit einem Eingangsanschluss des Hauptsteuermoduls verbunden ist;
das Stromerfassungsmodul dazu eingerichtet ist, einen Laststrom am Ausgangsanschluss des Optokopplermoduls zu erfassen und den Laststrom dem Oberstromgrenzwert-Vergleichsmodul sowie dem Unterstromgrenzwert-Vergleichsmodul bereitzustellen;
das Oberstromgrenzwert-Vergleichsmodul dazu eingerichtet ist, den Laststrom mit einem eingestellten oberen Stromgrenzwert zu vergleichen und zu bestimmen, ob der Laststrom den oberen Stromgrenzwert überschreitet, um ein Oberstromgrenzwert-Vergleichsergebnis zu erhalten;
das Unterstromgrenzwert-Vergleichsmodul dazu eingerichtet ist, den Laststrom mit einem eingestellten unteren Stromgrenzwert zu vergleichen und zu bestimmen, ob der Laststrom den unteren Stromgrenzwert erreicht, um ein Unterstromgrenzwert-Vergleichsergebnis zu erhalten;
das Spannungserfassungsmodul dazu eingerichtet ist, eine Lastspannung zu erfassen und die Lastspannung dem Spannungsvergleichsmodul bereitzustellen;
das Spannungsvergleichsmodul ist dazu eingerichtet, die Lastspannung mit einer eingestellten Kurzschlussspannung zu vergleichen und zu bestimmen, ob die Lastspannung die Kurzschlussspannung erreicht, um ein Spannungsvergleichsergebnis zu erhalten; und
das Hauptsteuermodul dazu eingerichtet ist, ein Einschaltsignal auszugeben, um das Optokopplermodul einzuschalten, und das vom isolierten Rückkopplungsmodul eingegebene Oberstromgrenzwert-Vergleichsergebnis, Unterstromgrenzwert-Vergleichsergebnis und Spannungsvergleichsergebnis auszulesen, um zu ermitteln, ob der Ausgangsanschluss des Optokopplermoduls eingeschaltet ist; und das Hauptsteuermodul ferner dazu eingerichtet ist, ein Abschaltsignal auszugeben, um das Optokopplermodul abzuschalten, und das vom isolierten Rückkopplungsmodul eingegebene Oberstromgrenzwert-Vergleichsergebnis, Unterstromgrenzwert-Vergleichsergebnis und Spannungsvergleichsergebnis auszulesen, um zu ermitteln, ob der Ausgangsanschluss des Optokopplermoduls abgeschaltet ist.

2. Isolierte Rückkopplungsschaltung nach Anspruch 1, wobei das Stromerfassungsmodul einen ersten Operationsverstärker (U3), einen ersten Widerstand (R1) und einen dritten Widerstand (R3) umfasst;
wobei ein nichtinvertierender Eingang des ersten Operationsverstärkers (U3) mit dem Optokopplermodul verbunden ist, ein invertierender Eingang des ersten Operationsverstärkers (U3) über den ersten Widerstand (R1) geerdet ist und ein Ausgangsanschluss des ersten Operationsverstärkers (U3) mit dem Oberstromgrenzwert-Vergleichsmodul verbunden ist; und
ein Anschluss des dritten Widerstands (R3) mit dem Ausgangsanschluss des ersten Operationsverstärkers (U3) verbunden ist und ein anderer Anschluss des dritten Widerstands (R3) zwischen dem invertierendem Eingang des ersten Operationsverstärkers (U3) und dem ersten Widerstand (R1) verbunden ist.

3. Isolierte Rückkopplungsschaltung nach Anspruch 2, wobei das Oberstromgrenzwert-Vergleichsmodul einen ersten Spannungsvergleicher (U5), einen vierzehnten Widerstand (R14), einen fünfzehnten Widerstand (R15) und eine erste Spannungsreferenzquelle (VREF1) umfasst;
wobei ein Anschluss des vierzehnten Widerstands (R14) mit einem Versorgungsspannungsanschluss des ersten Spannungsvergleichers (U5) verbunden ist, ein anderer Anschluss des vierzehnten Widerstands (R14) mit einem Anschluss des fünfzehnten Widerstands (R15) verbunden ist und ein anderer Anschluss des fünfzehnten Widerstands (R15) geerdet ist;
ein nichtinvertierender Eingang des ersten Spannungsvergleichers (U5) mit der ersten Spannungsreferenzquelle (VREF1) verbunden ist und dann mit dem Verbindungspunkt zwischen dem vierzehnten Widerstand (R14) und dem fünfzehnten Widerstand (R15) verbunden ist;
ein invertierender Eingang des ersten Spannungsvergleichers (U5) mit dem Ausgangsanschluss des ersten Operationsverstärkers (U3) verbunden ist; und
ein Ausgangsanschluss des ersten Spannungsvergleichers (U5) mit dem ersten Eingangsanschluss des isolierten Rückkopplungsmoduls verbunden ist.

4. Isolierte Rückkopplungsschaltung nach Anspruch 3, wobei das Unterstromgrenzwert-Vergleichsmodul einen zweiten Spannungsvergleicher (U6), einen sechzehnten Widerstand (R16), einen siebzehnten Widerstand (R17) und eine zweite Spannungsreferenzquelle (VREF2) umfasst;
wobei ein Anschluss des sechzehnten Widerstands (R16) mit einem Versorgungsspannungsanschluss des zweiten Spannungsvergleichers (U6) verbunden ist, ein anderer Anschluss des sechzehnten Widerstands (R16) mit einem Anschluss des siebzehnten Widerstands (R17) verbunden ist und ein anderer Anschluss des siebzehnten Widerstands (R17) geerdet ist;
ein nichtinvertierender Eingang des zweiten Spannungsvergleichers (U6) mit der zweiten Spannungsreferenzquelle (VREF2) verbunden ist und dann mit dem Verbindungspunkt zwischen dem sechzehnten Widerstand (R16) und dem siebzehnten Widerstand (R17) verbunden ist;
ein invertierender Eingang des zweiten Spannungsvergleichers (U6) mit dem Ausgangsanschluss des ersten Operationsverstärkers (U3) verbunden ist; und
ein Ausgangsanschluss des zweiten Spannungsvergleichers (U6) mit dem zweiten Eingangsanschluss des isolierten Rückkopplungsmoduls verbunden ist.

5. Isolierte Rückkopplungsschaltung nach Anspruch 4, wobei das Spannungserfassungsmodul einen zweiten Operationsverstärker (U4), einen sechsundzwanzigsten Widerstand (R26), einen siebenundzwanzigsten Widerstand (R27), einen achtundzwanzigsten Widerstand (R28) und einen neunundzwanzigsten Widerstand (R29) umfasst;
wobei ein nichtinvertierender Eingang des zweiten Operationsverstärkers (U4) über den siebenundzwanzigsten Widerstand (R27) mit einem ersten Anschluss der Last verbunden ist, ein invertierender Eingang des zweiten Operationsverstärkers (U4) über den sechsundzwanzigsten Widerstand (R26) mit einem zweiten Anschluss der Last verbunden ist und ein Ausgangsanschluss des zweiten Operationsverstärkers (U4) mit dem Eingangsanschluss des Spannungsvergleichsmoduls verbunden ist;
ein Anschluss des achtundzwanzigsten Widerstands (R28) zwischen dem zweiten Operationsverstärker (U4) und dem sechsundzwanzigsten Widerstand (R26) verbunden ist und ein anderer Anschluss des achtundzwanzigsten Widerstands (R28) mit dem Ausgangsanschluss des zweiten Operationsverstärkers (U4) verbunden ist; und
ein Anschluss des neunundzwanzigsten Widerstands (R29) zwischen dem zweiten Operationsverstärker (U4) und dem siebenundzwanzigsten Widerstand (R27) verbunden ist und ein anderer Anschluss des neunundzwanzigsten Widerstands (R29) geerdet ist.

6. Isolierte Rückkopplungsschaltung nach Anspruch 5, wobei das Spannungsvergleichsmodul einen dritten Spannungsvergleicher (U7), einen zwanzigsten Widerstand (R20), einen einundzwanzigsten Widerstand (R21) und eine dritte Spannungsreferenzquelle (VREF3) umfasst;
wobei ein Anschluss des zwanzigsten Widerstands (R20) mit einem Versorgungsspannungsanschluss des dritten Spannungsvergleichers (U7) verbunden ist, ein anderer Anschluss des zwanzigsten Widerstands (R20) mit einem Anschluss des einundzwanzigsten Widerstands (R21) verbunden ist und ein anderer Anschluss des einundzwanzigsten Widerstands (R21) geerdet ist;
ein nichtinvertierender Eingang des dritten Spannungsvergleichers (U7) mit der dritten Spannungsreferenzquelle (VREF3) verbunden ist und dann mit dem Verbindungspunkt zwischen dem zwanzigsten Widerstand (R20) und dem einundzwanzigsten Widerstand (R21) verbunden ist;
ein invertierender Eingang des dritten Spannungsvergleichers (U7) mit dem Ausgangsanschluss des zweiten Operationsverstärkers (U4) verbunden ist; und
ein Ausgangsanschluss des dritten Spannungsvergleichers (U7) mit dem dritten Eingangsanschluss des isolierten Rückkopplungsmoduls verbunden ist.

7. Isolierte Rückkopplungsschaltung nach Anspruch 6, wobei das isolierte Rückkopplungsmodul einen ersten Optokoppler (U8), einen zweiten Optokoppler (U9), einen dritten Optokoppler (U10), einen Isolationsbaustein (U11), einen fünften Widerstand (R5), einen sechsten Widerstand (R6), einen siebten Widerstand (R7), einen achten Widerstand (R8), einen vierundzwanzigsten Widerstand (R24) und einen fünfundzwanzigsten Widerstand (R25) umfasst;
wobei ein erster Pin des ersten Optokopplers (U8) mit einem Anschluss des fünften Widerstands (R5) verbunden ist, ein zweiter Pin des ersten Optokopplers (U8) mit dem Ausgangsanschluss des ersten Spannungsvergleichers (U5) verbunden ist, ein dritter Pin des ersten Optokopplers (U8) geerdet ist und ein vierter Pin des ersten Optokopplers (U8) jeweils mit einem Anschluss des siebten Widerstands (R7) und dem Eingangsanschluss des Hauptsteuermoduls verbunden ist;
ein erster Pin des zweiten Optokopplers (U9) mit einem Anschluss des sechsten Widerstands (R6) verbunden ist, ein zweiter Pin des zweiten Optokopplers (U9) mit dem Ausgangsanschluss des zweiten Spannungsvergleichers (U6) verbunden ist, ein dritter Pin des zweiten Optokopplers (U9) geerdet ist und ein vierter Pin des zweiten Optokopplers (U9) jeweils mit einem Anschluss des achten Widerstands (R8) und dem Eingangsanschluss des Hauptsteuermoduls verbunden ist; und
ein erster Pin des dritten Optokopplers (U10) mit einem Anschluss des vierundzwanzigsten Widerstands (R24) verbunden ist, ein zweiter Pin des dritten Optokopplers (U10) mit dem Ausgangsanschluss des dritten Spannungsvergleichers (U7) verbunden ist, ein dritter Pin des dritten Optokopplers (U10) geerdet ist und ein vierter Pin des dritten Optokopplers (U10) jeweils mit einem Anschluss des fünfundzwanzigsten Widerstands (R25) und dem Eingangsanschluss des Hauptsteuermoduls verbunden ist.

8. Isolierte Rückkopplungsschaltung nach Anspruch 7, wobei das Hauptsteuermodul einen Hauptsteuerbaustein (U1), einen neunten Widerstand (R9), einen elften Widerstand (R11), einen zwölften Widerstand (R12), einen dreizehnten Widerstand (R13), einen ersten Kondensator (C1), einen zweiten Kondensator (C2), einen dritten Kondensator (C3) und einen Quarzoszillator (Y1) umfasst;
wobei ein PA0-Pin des Hauptsteuerbausteins (U1) mit dem zweiten Eingangsanschluss des Optokopplermoduls verbunden ist, ein PA1-Pin des Hauptsteuerbausteins (U1) mit dem vierten Pin des ersten Optokopplers (U8) verbunden ist, ein PA2-Pin des Hauptsteuerbausteins (U1) mit dem vierten Pin des zweiten Optokopplers (U9) verbunden ist und ein PA3-Pin des Hauptsteuerbausteins (U1) mit dem vierten Pin des dritten Optokopplers (U10) verbunden ist;
ein Anschluss des elften Widerstands (R11) mit einem BOOT2-Pin des Hauptsteuerbausteins (U1) verbunden ist und ein anderer Anschluss des elften Widerstands (R11) geerdet ist;
ein Anschluss des zwölften Widerstands (R12) mit einem BOOT1-Pin des Hauptsteuerbausteins (U1) verbunden ist und ein anderer Anschluss des zwölften Widerstands (R12) geerdet ist;
ein Anschluss des dritten Kondensators (C3) mit einem OSC_0-Pin des Hauptsteuerbausteins (U1) verbunden ist und ein anderer Anschluss des dritten Kondensators (C3) geerdet ist;
ein Anschluss des zweiten Kondensators (C2) mit einem OCS_1-Pin des Hauptsteuerbausteins (U1) verbunden ist und ein anderer Anschluss des zweiten Kondensators (C2) geerdet ist;
ein Anschluss des dreizehnten Widerstands (R13) zwischen dem OSC_0-Pin des Hauptsteuerbausteins (U1) und dem dritten Kondensator (C3) verbunden ist und ein anderer Anschluss des dreizehnten Widerstands (R13) zwischen dem OCS_1-Pin des Hauptsteuerbausteins (U1) und dem zweiten Kondensator (C2) verbunden ist; und
ein Anschluss des Quarzoszillators (Y1) zwischen dem OSC_0-Pin des Hauptsteuerbausteins (U1) und dem dritten Kondensator (C3) verbunden ist und ein anderer Anschluss des Quarzoszillators (Y1) zwischen dem OCS_1-Pin des Hauptsteuerbausteins (U1) und dem zweiten Kondensator (C2) verbunden ist.

9. Isolierte Rückkopplungsschaltung nach Anspruch 8, wobei das Optokopplermodul einen vierten Optokoppler (U2), einen N-Kanal-Metalloxid-Halbleitertransistor (NMOS-Transistor) (Q1), einen achtzehnten Widerstand (R18), einen neunzehnten Widerstand (R19), einen Parameterwiderstand (Rout) und eine zweite Diode (D2) umfasst;
wobei ein erster Pin des vierten Optokopplers (U2) über den achtzehnten Widerstand (R18) mit dem PA0-Pin des Hauptsteuerbausteins (U1) verbunden ist, ein zweiter Pin des vierten Optokopplers (U2) geerdet ist und ein dritter Pin des vierten Optokopplers (U2) mit einem Gate des NMOS-Transistors (Q1) verbunden ist;
ein Anschluss des neunzehnten Widerstands (R19) zwischen dem dritten Pin des vierten Optokopplers (U2) und dem Gate des NMOS-Transistors (Q1) verbunden ist und ein anderer Anschluss des neunzehnten Widerstands (R19) geerdet ist;
ein Anschluss des Parameterwiderstands (Rout) mit einer Source des NMOS-Transistors (Q1) verbunden ist und ein anderer Anschluss des Parameterwiderstands (Rout) geerdet ist;
eine Drain des NMOS-Transistors (Q1) mit dem zweiten Anschluss der Last verbunden ist; und
eine Anode der zweiten Diode (D2) jeweils mit der Source des NMOS-Transistors (Q1) und dem nichtinvertierendem Eingang des ersten Operationsverstärkers (U3) verbunden ist und eine Kathode der zweiten Diode (D2) mit der Drain des NMOS-Transistors (Q1) verbunden ist.

10. Isolierte Rückkopplungsschaltung nach Anspruch 9, wobei die Last ein Relais und eine erste Diode (D1) umfasst;
wobei ein Anschluss des Relais jeweils mit der Drain des NMOS-Transistors (Q1), dem sechsundzwanzigsten Widerstand (R26) und einer Anode der ersten Diode (D1) verbunden ist und ein anderer Anschluss des Relais jeweils mit dem siebenundzwanzigsten Widerstand (R27) und einer Kathode der ersten Diode (D1) verbunden ist.

## Revendications

1. Circuit de rétroaction isolé pour la détection d'un état de sortie d'un optocoupleur, appliqué à un module optocoupleur, dans lequel une première borne d'entrée du module optocoupleur est connectée à une charge, et le circuit comprend un module de commande principal, un module de détection de sortie et un module de rétroaction isolé ; dans lequel
le module de détection de sortie comprend un module de détection de courant, un module de comparaison de limite supérieure de courant, un module de comparaison de limite inférieure de courant, un module de détection de tension et un module de comparaison de tension ;
une deuxième borne d'entrée du module optocoupleur est connectée à une borne de sortie du module de commande principal, et une borne de sortie du module optocoupleur est connectée à une borne d'entrée du module de détection de courant ;
une borne de sortie du module de détection de courant est connectée séparément à une borne d'entrée du module de comparaison de limite supérieure de courant et à une borne d'entrée du module de comparaison de limite inférieure de courant ;
des bornes d'entrée du module de détection de tension sont connectées en parallèle avec la charge, et une borne de sortie du module de détection de tension est connectée à une borne d'entrée du module de comparaison de tension ;
une borne de sortie du module de comparaison de limite supérieure de courant est connectée à une première borne d'entrée du module de rétroaction isolé, une borne de sortie du module de comparaison de limite inférieure de courant est connectée à une deuxième borne d'entrée du module de rétroaction isolé, et une borne de sortie du module de comparaison de tension est connectée à une troisième borne d'entrée du module de rétroaction isolé ;
une borne de sortie du module de rétroaction isolé est connectée à une borne d'entrée du module de commande principal ;
le module de détection de courant est configuré pour détecter un courant de charge au niveau de la borne de sortie du module optocoupleur et pour fournir le courant de charge pour le module de comparaison de limite supérieure de courant et le module de comparaison de limite inférieure de courant ;
le module de comparaison de limite supérieure de courant est configuré pour comparer le courant de charge à une limite supérieure de courant définie et pour déterminer si le courant de charge dépasse la limite supérieure de courant pour obtenir un résultat de comparaison de limite supérieure de courant ;
le module de comparaison de limite inférieure de courant est configuré pour comparer le courant de charge à une limite inférieure de courant définie et pour déterminer si le courant de charge atteint la limite inférieure de courant pour obtenir un résultat de comparaison de limite inférieure de courant ;
le module de détection de tension est configuré pour détecter une tension de charge et pour fournir la tension de charge pour le module de comparaison de tension ;
le module de comparaison de tension est configuré pour comparer la tension de charge à une tension de court-circuit définie et pour déterminer si la tension de charge atteint la tension de court-circuit pour obtenir un résultat de comparaison de tension ; et
le module de commande principal est configuré pour délivrer en sortie un signal de conduction pour activer le module optocoupleur et lire le résultat de comparaison de limite supérieure de courant, le résultat de comparaison de limite inférieure de courant, et le résultat de comparaison de tension entré par le module de rétroaction isolé pour apprendre si la borne de sortie du module optocoupleur est activée ; et le module de commande principal est configuré pour délivrer en sortie un signal de coupure pour couper le module optocoupleur et lire le résultat de comparaison de limite supérieure de courant, le résultat de comparaison de limite inférieure de courant, et le résultat de comparaison de tension entré par le module de rétroaction isolé pour apprendre si la borne de sortie du module optocoupleur est coupée.

2. Circuit de rétroaction isolé selon la revendication 1, dans lequel le module de détection de courant comprend un premier amplificateur opérationnel (U3), une première résistance (R1) et une troisième résistance (R3) ;
dans lequel une borne d'entrée positive du premier amplificateur opérationnel (U3) est connectée au module optocoupleur, une borne d'entrée négative du premier amplificateur opérationnel (U3) est mise à la terre à travers la première résistance (R1), et une borne de sortie du premier amplificateur opérationnel (U3) est connectée au module de comparaison de limite supérieure de courant ; et
une borne de la troisième résistance (R3) est connectée à la borne de sortie du premier amplificateur opérationnel (U3), et une autre borne de la troisième résistance (R3) est connectée entre la borne d'entrée négative du premier amplificateur opérationnel (U3) et la première résistance (R1).

3. Circuit de rétroaction isolé selon la revendication 2, dans lequel le module de comparaison de limite supérieure de courant comprend un premier comparateur de tension (U5), une quatorzième résistance (R14), une quinzième résistance (R15) et une première source de référence de tension (VREF1) ;
dans lequel une borne de la quatorzième résistance (R14) est connectée à une borne d'alimentation du premier comparateur de tension (U5), une autre borne de la quatorzième résistance (R14) est connectée à une borne de la quinzième résistance (R15), et une autre borne de la quinzième résistance (R15) est mise à la terre ;
une borne d'entrée positive du premier comparateur de tension (U5) est connectée à la première source de référence de tension (VREF1) et ensuite connectée entre la quatorzième résistance (R14) et la quinzième résistance (R15) ;
une borne d'entrée négative du premier comparateur de tension (U5) est connectée à la borne de sortie du premier amplificateur opérationnel (U3) ; et
une borne de sortie du premier comparateur de tension (U5) est connectée à la première borne d'entrée du module de rétroaction isolé.

4. Circuit de rétroaction isolé selon la revendication 3, dans lequel le module de comparaison de limite inférieure de courant comprend un deuxième comparateur de tension (U6), une seizième résistance (R16), une dix-septième résistance (R17) et une deuxième source de référence de tension (VREF2) ;
dans lequel une borne de la seizième résistance (R16) est connectée à une borne d'alimentation du deuxième comparateur de tension (U6), une autre borne de la seizième résistance (R16) est connectée à une borne de la dix-septième résistance (R17), et une autre borne de la dix-septième résistance (R17) est mise à la terre ;
une borne d'entrée positive du deuxième comparateur de tension (U6) est connectée à la deuxième source de référence de tension (VREF2) et ensuite connectée entre la seizième résistance (R16) et la dix-septième résistance (R17) ;
une borne d'entrée négative du deuxième comparateur de tension (U6) est connectée à la borne de sortie du premier amplificateur opérationnel (U3) ; et
une borne de sortie du deuxième comparateur de tension (U6) est connectée à la deuxième borne d'entrée du module de rétroaction isolé.

5. Circuit de rétroaction isolé selon la revendication 4, dans lequel le module de détection de tension comprend un deuxième amplificateur opérationnel (U4), une vingt-sixième résistance (R26), une vingt-septième résistance (R27), une vingt-huitième résistance (R28) et une vingt-neuvième résistance (R29) ;
dans lequel une borne d'entrée positive du deuxième amplificateur opérationnel (U4) est connectée à une première borne de la charge à travers la vingt-septième résistance (R27), une borne d'entrée négative du deuxième amplificateur opérationnel (U4) est connectée à une deuxième borne de la charge à travers la vingt-sixième résistance (R26), et une borne de sortie du deuxième amplificateur opérationnel (U4) est connectée à la borne d'entrée du module de comparaison de tension ;
une borne de la vingt-huitième résistance (R28) est connectée entre le deuxième amplificateur opérationnel (U4) et la vingt-sixième résistance (R26), et une autre borne de la vingt-huitième résistance (R28) est connectée à la borne de sortie du deuxième amplificateur opérationnel (U4) ; et
une borne de la vingt-neuvième résistance (R29) est connectée entre le deuxième amplificateur opérationnel (U4) et la vingt-septième résistance (R27), et une autre borne de la vingt-neuvième résistance (R29) est mise à la terre.

6. Circuit de rétroaction isolé selon la revendication 5, dans lequel le module de comparaison de tension comprend un troisième comparateur de tension (U7), une vingtième résistance (R20), une vingt-première résistance (R21) et une troisième source de référence de tension (VREF3) ;
dans lequel une borne de la vingtième résistance (R20) est connectée à une borne d'alimentation du troisième comparateur de tension (U7), une autre borne de la vingtième résistance (R20) est connectée à une borne de la vingt-première résistance (R21), et une autre borne de la vingt-première résistance (R21) est mise à la terre ;
une borne d'entrée positive du troisième comparateur de tension (U7) est connectée à la troisième source de référence de tension (VREF3) et ensuite connectée entre la vingtième résistance (R20) et la vingt-première résistance (R21) ;
une borne d'entrée négative du troisième comparateur de tension (U7) est connectée à la borne de sortie du deuxième amplificateur opérationnel (U4) ; et
une borne de sortie du troisième comparateur de tension (U7) est connectée à la troisième borne d'entrée du module de rétroaction isolé.

7. Circuit de rétroaction isolé selon la revendication 6, dans lequel le module de rétroaction isolé comprend un premier optocoupleur (U8), un deuxième optocoupleur (U9), un troisième optocoupleur (U10), une puce d'isolation (U11), une cinquième résistance (R5), une sixième résistance (R6), une septième résistance (R7), une huitième résistance (R8), une vingt-quatrième résistance (R24) et une vingt-cinquième résistance (R25) ;
dans lequel une première broche du premier optocoupleur (U8) est connectée à une borne de la cinquième résistance (R5), une deuxième broche du premier optocoupleur (U8) est connectée à la borne de sortie du premier comparateur de tension (U5), une troisième broche du premier optocoupleur (U8) est mise à la terre, et une quatrième broche du premier optocoupleur (U8) est connectée séparément à une borne de la septième résistance (R7) et à la borne d'entrée du module de commande principal ;
une première broche du deuxième optocoupleur (U9) est connectée à une borne de la sixième résistance (R6), une deuxième broche du deuxième optocoupleur (U9) est connectée à la borne de sortie du deuxième comparateur de tension (U6), une troisième broche du deuxième optocoupleur (U9) est mise à la terre, et une quatrième broche du deuxième optocoupleur (U9) est connectée séparément à une borne de la huitième résistance (R8) et à la borne d'entrée du module de commande principal ; et
une première broche du troisième optocoupleur (U10) est connectée à une borne de la vingt-quatrième résistance (R24), une deuxième broche du troisième optocoupleur (U10) est connectée à la borne de sortie du troisième comparateur de tension (U7), une troisième broche du troisième optocoupleur (U10) est mise à la terre, et une quatrième broche du troisième optocoupleur (U10) est connectée séparément à une borne de la vingt-cinquième résistance (R25) et à la borne d'entrée du module de commande principal.

8. Circuit de rétroaction isolé selon la revendication 7, dans lequel le module de commande principal comprend une puce de commande principale (U1), une neuvième résistance (R9), une onzième résistance (R11), une douzième résistance (R12), une treizième résistance (R13), un premier condensateur (C1), un deuxième condensateur (C2), un troisième condensateur (C3) et un oscillateur à quartz (Y1) ;
dans lequel une broche PA0 de la puce de commande principale (U1) est connectée à la deuxième borne d'entrée du module optocoupleur, une broche PA1 de la puce de commande principale (U1) est connectée à la quatrième broche du premier optocoupleur (U8), une broche PA2 de la puce de commande principale (U1) est connectée à la quatrième broche du deuxième optocoupleur (U9), et une broche PA3 de la puce de commande principale (U1) est connectée à la quatrième broche du troisième optocoupleur (U10) ;
une borne de l'onzième résistance (R11) est connectée à une broche BOOT2 de la puce de commande principale (U1), et une autre borne de l'onzième résistance (R11) est mise à la terre ;
une borne de la douzième résistance (R12) est connectée à une broche BOOT1 de la puce de commande principale (U1), et une autre borne de la douzième résistance (R12) est mise à la terre ;
une borne du troisième condensateur (C3) est connectée à une broche OSC_0 de la puce de commande principale (U1), et une autre borne du troisième condensateur (C3) est mise à la terre ;
une borne du deuxième condensateur (C2) est connectée à une broche OCS_1 de la puce de commande principale (U1), et une autre borne du deuxième condensateur (C2) est mise à la terre ;
une borne de la treizième résistance (R13) est connectée entre la broche OSC_0 de la puce de commande principale (U1) et le troisième condensateur (C3), et une autre borne de la treizième résistance (R13) est connectée entre la broche OCS_1 de la puce de commande principale (U1) et le deuxième condensateur (C2) ; et
une borne de l'oscillateur à quartz (Y1) est connectée entre la broche OSC_0 de la puce de commande principale (U1) et le troisième condensateur (C3), et une autre borne de l'oscillateur à quartz (Y1) est connectée entre la broche OCS_1 de la puce de commande principale U1 et le deuxième condensateur (C2).

9. Circuit de rétroaction isolé selon la revendication 8, dans lequel le module optocoupleur comprend un quatrième optocoupleur (U2), un transistor à semi-conducteur à oxyde métallique à canal N, NMOS, (Q1), une dix-huitième résistance (R18), une dix-neuvième résistance (R19), une résistance de paramètre (Rout) et une deuxième diode (D2) ;
dans lequel une première broche du quatrième optocoupleur (U2) est connectée à la broche PA0 de la puce de commande principale (U1) à travers la dix-huitième résistance (R18), une deuxième broche du quatrième optocoupleur (U2) est mise à la terre, et une troisième broche du quatrième optocoupleur (U2) est connectée à une grille du transistor NMOS (Q1) ;
une borne de la dix-neuvième résistance (R19) est connectée entre la troisième broche du quatrième optocoupleur (U2) et la grille du transistor NMOS (Q1), et une autre borne de la dix-neuvième résistance (R19) est mise à la terre ;
une borne de la résistance de paramètre Rout est connectée à une source du transistor NMOS Q1, et une autre borne de la résistance de paramètre Rout est mise à la terre ;
un drain du transistor NMOS (Q1) est connecté à la deuxième borne de la charge ; et
une anode de la deuxième diode (D2) est connectée séparément à la source du transistor NMOS (Q1) et à la borne d'entrée positive du premier amplificateur opérationnel (U3), et une cathode de la deuxième diode (D2) est connectée au drain du transistor NMOS (Q1).

10. Circuit de rétroaction isolé selon la revendication 9, dans lequel la charge comprend un relais et une première diode (D1) ;
dans lequel une borne du relais est connectée séparément au drain du transistor NMOS (Q1), à la vingt-sixième résistance (R26) et à une anode de la première diode (D1), et une autre borne du relais est connectée séparément à la vingt-septième résistance (R27) et à une cathode de la première diode (D1).
